# EUROPÄISCHE PATENTANMELDUNG

(11) **EP 3 816 841 A1**
(43) Veröffentlichungstag der Anmeldung: **05.05.2021**
(21) Anmeldenummer: 20205248.6
(22) Anmeldetag: 02.11.2020
(51) Int. Cl.: G06F 30/13, E04B 1/00

(54) **VERFAHREN UND EINRICHTUNG ZUR AUSWAHL UND/ODER POSITIONIERUNG VON MINDESTENS EINEM BETONTEIL-VERBINDUNGSELEMENT**

(30) Priorität: 31.10.2019 EP 19206589
(71) Anmelder: Schöck Bauteile GmbH, 76534 Baden-Baden (DE)
(72) Erfinder:
(74) Vertreter: König, Gregor Sebastian

(57) **Zusammenfassung**

Die Erfindung betrifft ein Verfahren und eine Einrichtung zur Auswahl und/oder Positionierung von mindestens einem Betonteil-Verbindungselement (1, 1a, 1b), welches bzw. welche vorgesehen ist/sind, zwischen einem von einem Gebäude (2) auskragenden Betonteil (3) und einer Gebäudefassade (4) angeordnet zu werden, umfassend die folgenden Schritte:
- Modifizieren (C) eines statisch gültigen vorläufigen Einbauplans (21) durch einen Abwandlungsalgorithmus (31) zur Erzeugung mindestens eines alternativen Einbauplans (32), wobei der Abwandlungsalgorithmus (31) zur Abwandlung des vorläufigen Einbauplans (21) in den alternativen Einbauplan (31) Werte einer hinsichtlich mehrerer Dimensionierungskriterien (P1, P2, P3, P4, P5) parametrierbaren Gütefunktion ermittelt und den vorläufigen Einbauplan (21) derart im Rahmen der statischen Gültigkeit abwandelt, dass die Gütefunktion ein Maximum annimmt; und
- Ausgeben des alternativen Einbauplans (31).

## Beschreibung

Die vorliegende Erfindung betrifft ein Verfahren sowie eine Einrichtung zur Auswahl und/oder Positionierung von mindestens einem Betonteil-Verbindungselement, welches vorgesehen ist, zwischen einem von einem Gebäude auskragenden Betonteil und einer Gebäudefassade angeordnet zu werden. Außerdem betrifft die Erfindung auch ein Verfahren zum Einbauen eines Betonteil-Verbindungselements.

Das Einsatzgebiet der Erfindung ist die Bautechnik, insbesondere in Bezug auf die Umsetzung einer statischen Planung eines von einem Gebäude auskragenden Betonteils, beispielsweise eines Fertigteilbalkons, in eine den bautechnischen Vorschriften und konstruktiven Randbedingungen entsprechende Ausführungsplanung.

Als Betonteil-Verbindungselement kommt im Rahmen der vorliegenden Erfindung insbesondere ein allgemein bekanntes tragendes Wärmedämmelement in Betracht, mittels welchem als eine Art einbetonierbares Brückenelement die gewünschte Verbindung einfach und sicher hergestellt werden kann. Mit anderen Worten dient ein solches Betonteil-Verbindungselement dabei als Anschlussteil, mit dem sich auch die erforderliche thermische Trennung sowie Wärmedämmung der miteinander zu verbindenden Teile, nämlich dem auskragenden Betonteil und die Gebäudefassade des Gebäudes, realisieren lassen kann. Insoweit kann ein Betonteil-Verbindungselement im Wesentlichen aus einem Dämmkörper und einem Drucklager aus vorzugsweise Hochleistungs-Feinbeton und mehreren den Dammkörper durchdringenden Armierungsstäben mit freibleibenden Enden, die einerseits seitens der Gebäudefassade im Bereich einer Betondecke und andererseits am auskragenden Gebäudeteil einbetoniert werden können. Daneben können noch auf diesem Grundprinzip basierende andere Betonteil-Verbindungselemente zum Einsatz kommen, welche zumindest einseitig mit den besagten Armierungsstäben ausgestattet sind. Auch diese ähnlichen Betonteil-Verbindungselemente sind von der nachfolgend beschriebenen Erfindung mit umfasst.

Im Rahmen der Ausführungsplanung für die konkrete Auswahl und Positionierung gattungsgemäßer Betonteil-Verbindungselemente ist gemäß dem allgemein bekannten Stand der Technik nach Maßgabe des aus der statischen Planung resultierenden Momenten- und Querkraftverlaufs zu dimensionieren. Dies bedeutet, dass aus verschiedenen Varianten von Betonteil-Verbindungselementen diejenigen auszusuchen sind, welche den konkreten statischen Erfordernissen entsprechen, also hinsichtlich der aufnehmbaren Lasten und der geometrischen Abmessungen passend sind. Jedoch können in der Praxis oftmals die aus statischen Gesichtspunkten optimalen Verbindungsstellen nicht mit einem Betonteilverbindungselement bestückt werden, da dann beispielsweise vorgeschriebene Mindestrandabstande zu Gebäudekanten oder dergleichen nicht eingehalten werden können. Hieraus resultiert auch die Gefahr, dass erst auf der Baustelle im Zuge der Montage bemerkt wird, dass eine vormontierte Baueinheit, die beispielsweise als Balkon mit Betonteilverbindungselement(en) ausgestaltet ist, so nicht montierbar ist, woraus ein erheblicher Nachbearbeitungsaufwand resultieren kann.

Es ist daher Aufgabe der vorliegenden Erfindung, ein Verfahren sowie eine Einrichtung zur Auswahl und/oder Positionierung von mindestens einem Betonteil-Verbindungselement sowie ein Verfahren zum Einbauen eines Betonteil-Verbindungselements zu schaffen, welches bzw. welche in einfacher Weise eine in Bezug auf die vorstehend geschilderte Problematik fehlerreduzierende Planung und/oder Ausführung ermöglicht.

Die Aufgabe wird mittels eines Verfahrens gemäß Anspruch 1 oder 2 gelöst. Der Anspruch 15 gibt eine das Verfahren zur Auswahl und/oder Positionierung von mindestens einem Betonteil-Verbindungselement ausführende rechnergestützte Einrichtung an.

Ein statisch gültiger vorläufiger Einbauplan wird zur Erzeugung mindestens eines alternativen Einbauplans modifiziert. Ein Abwandlungsalgorithmus ermittelt zur Abwandlung des vorläufigen Einbauplans in den alternativen Einbauplan Werte einer hinsichtlich mehrerer Dimensionierungskriterien parametrierbaren Gütefunktion. Der vorläufige Einbauplan wird derart im Rahmen der statischen Gültigkeit abgewandelt, dass die Gütefunktion ein Maximum annimmt. Der alternative Einbauplan wird ausgegeben.

Unter dem Begriff der Ermittlung der Werte einer hinsichtlich mehrerer Dimensionierungskriterien parametrierbaren Gütefunktion wird eine Bestimmung der Werte der Gütefunktion in Abhängigkeit von Parameterwerten der Dimensionierungskriterien verstanden. Die Parameterwerte der Dimensionierungskriterien können einzeln oder in Abhängigkeit voneinander eingegeben und/oder verändert werden.

Es können Werte der Parameter der Dimensionierungskriterien vorgegeben bzw. eingegeben und/oder Werte berechnet werden, die sich insbesondere aus einer Eingabe bzw. Veränderung eines der Werte für eines der Dimensionierungskriterien ergeben können.

Grundgedanke der vorliegenden Erfindung ist es, die statische Gültigkeit des zunächst vorgegebenen vorläufigen Einbauplans beizubehalten und unter Berücksichtigung der Dimensionierungskriterien einen Einbauplan zu erzeugen, der als alternativer Einbauplan bezeichnet wird. Der alternative Einbauplan kann optimiert werden.

Der Begriff des Ausgebens des alternativen Einbauplans umfasst sowohl eine Speicherung des Einbauplans in Form einer Ablage im Speicher eines Computers, der insbesondere ein nicht-flüchtiger Speicher sein kann. Der Begriff des Ausgebens des alternativen Einbauplans beinhaltet auch eine physikalische Ausgabe, insbesondere in Form eines Druckens des Einbauplans, um diesen weitergeben zu können. Das Ausdrucken des alternativen Einbauplans kann die Möglichkeit vorsehen, dass der Einbauplan abgezeichnet und/oder zur Verwendung durch einen Bauleiter, Rohbauer, Architekten und/oder Statiker weitergegeben werden kann.

Ein Einbauen des mindestens einen Betonteil-Verbindungselements umfasst ein Einbetonieren des Betonteil-Verbindungselements an der Baustelle, bei dem das Betonteil-Verbindungselement erstmals fest mit dem Betonteil und der Gebäudefassade mittels Beton verbunden wird. Ein Einbauen des mindestens einen Betonteil-Verbindungselements kann auch eine einseitige Verbindung des Betonteil-Verbindungselements mit dem Betonteil sein, sodass das Betonteil mit dem Betonteil-Verbindungselement auf der Baustelle oder zuvor mittels Verwendung von Beton verbunden werden kann, bevor das Betonteil-Verbindungselement mit der Gebäudefassade mittels Beton fest verbunden wird.

Bei den Dimensionierungskriterien kann es sich allesamt um technische Ausgestaltungen der Auswahl und/oder Positionierung handeln. Die Dimensionierungskriterien können eine die statische Gültigkeit berücksichtigende a) Auswahl aus mehreren vorgegebenen Betonteil-Verbindungselementen, b) Wahl des Werkstoffs für das Betonteil-Verbindungselements und/oder eines für ein Einbetonieren verwendeten Betons, c) Positionieren des einen Betonteil-Verbindungselements oder mehrerer Betonteil-Verbindungselemente zueinander, und/oder d) technische Modifikation des Betonteil-Verbindungselements betreffen.

Bei der Auswahl aus mehreren vorgegebenen Betonteil-Verbindungselementen kann auf eine Datenbank von bestehenden bzw. angebotenen Betonteil-Verbindungselementen zurückgegriffen werden. Mittels der Abwandlung des Einbauplans kann beispielsweise ein anderes der vorgegebenen bzw. angebotenen Betonteil-Verbindungselemente im alternativen Einbauplan berücksichtigt werden, wobei ermittelt werden kann, ob die Gütefunktion ein Maximum annimmt. Es kann beispielsweise bei der Auswahl aus mehreren vorgegebenen Betonteil-Verbindungselementen auftreten, dass die statische Gültigkeit nicht mehr gegeben ist und/oder die Gütefunktion einen Wert annimmt, der kleiner als das Maximum bzw. ein zuvor erreichter Wert der Gütefunktion ist. Die Auswahl aus mehreren vorgegebenen Betonteil-Verbindungselementen stellt einen technischen Zusammenhang zu dem Betonteil und der Gebäudefassade dar.

Bei der Wahl des Werkstoffs für das Betonteil-Verbindungselements und/oder eines für ein Einbetonieren verwendeten Betons wird auf technische Eigenschaften des Werkstoffs bzw. des Betons zurückgegriffen, welche im technischen Kontext der Abwandlung zu einer Veränderung des Werts der Gütefunktion führen können.

Die Positionierung des einen Betonteil-Verbindungselements oder die Positionierung mehrerer Betonteil-Verbindungselemente zueinander beeinflusst die Gütefunktion hinsichtlich ihres Werts und führt zu einer Veränderung des Werts der Gütefunktion.

Der technische Zusammenhang kann gemäß einer bevorzugten Ausführungsform über die statische Gültigkeit erhalten bleiben, wenn mindestens ein Parameterwert eines Dimensionierungskriteriums verändert wird, indem die Parameterwerte der anderen Dimensionierungskriterien unter Beibehaltung der statischen Gültigkeit in Abhängigkeit auf die Veränderung des mindestens ein Parameterwerts angepasst werden. Beispielsweise kann bei der Veränderung eines der Parameterwerte für eines der Dimensionierungskriterien der Parameterwert eines anderen Dimensionierungskriteriums angepasst werden, um den Wert der Gütefunktion im Wesentlichen beizubehalten und/oder zu vergrößern.

Als Parameter der Gütefunktion können die Abmessungen des Betonteils, der Werkstoff des Betonteils, das Gewicht des Betonteils, ein zum Einbetonieren verwendeter Beton, eine technische Ausgestaltung des Betonteil-Verbindungselements und/oder mindestens ein Abstand des Betonteil-Verbindungselements zum Betonteil, zur Gebäudefassade und/oder zu einem weiteren Betonteil-Verbindungselement gewählt werden.

Ferner wird jeweils ein die Verfahren verkörperndes Computerprogramm beschrieben, wobei jedes der Computerprogramme auf einem computerlesbaren Datenträger abspeicherbar hinterlegt sein kann.

Die Erfindung schließt die verfahrenstechnische Lehre ein, zur rechnergestützten Auswahl und Positionierung von Betonteil-Verbindungselementen, die zwischen einem von einem Gebäude auskragenden Betonteil und einer Gebäudefassade angeordnet werden, die nachfolgenden Schritte computergestützt durchzuführen:
- Erstellung einer statischen Planung für ein an einer Gebäudefassade anzubringendes auskragendes Gebäudeteil mit Ausgabe des Momenten- und Querkraftverlaufs;
- Auswahl von zu dem Momenten- und Querkraftverlauf passenden Betonteilverbindungselementen und Erstellung eines statisch gültigen vorläufigen Einbauplans auf Basis des Momenten- und Querkraftverlaufs;
- Modifikation des vorläufigen Einbauplans durch einen Abwandlungsalgorithmus zur Erzeugung eines alternativen Einbauplans, wobei der Abwandlungsalgorithmus zur Abwandlung des vorläufigen Einbauplans in den alternativen Einbauplan Werte einer hinsichtlich mehrerer Dimensionierungskriterien parametrierbaren Gütefunktion ermittelt und den vorläufigen Einbauplan derart im Rahmen der statischen Gültigkeit abwandelt, dass die Gütefunktion ein Maximum annimmt.

Mit anderen Worten wird eine Art Assistenzsystem beschrieben, welches den Planer zum einen darin unterstützt, aus einer Vielzahl unterschiedlicher Varianten von Betonteil-Verbindungselementen und/oder möglichen Positionierungen eine weitere Lösung herauszufinden, die effizienter sein kann, und - im Sinne einer weiteren Dimension - dabei andererseits auch möglichst viele oder alle relevanten Dimensionierungskriterien, wie Gebäuderandabstände, Mindestabstände zwischen benachbarten Armierungsstäben und dergleichen, zu beachten. Die vorstehend geschilderte Problematik zeigt, dass bislang auftretende Fehler durch eine manuelle Planung nicht zu beherrschen waren. Somit zeichnen sich die erfindungsgemäßen Verfahren und die Einrichtung durch eine Fehlervermeidung sowie eine Verkürzung der Planungszeit bei der Dimensionierung sowie auch einer Verkürzung der Montagezeit auf der Baustelle aus, da Nacharbeiten aufgrund von Planungsfehlern weitestgehend vermieden werden können.

Mittels des die Gütefunktion beinhaltenden Abwandlungsalgorithmus kann die vorstehend beschriebene mehrdimensionale Problematik beherrscht werden. Denn in der mathematischen Gütefunktion ist verkörpert, möglichst viele Dimensionierungskriterien zu beachten, beispielsweise die Beachtung hinreichender Randabstände oder die Einhaltung von Mindestabständen von Bauteilen untereinander. Falls mehrere Ziele gleichzeitig erreicht werden sollen, so bietet unter Berücksichtigung der technischen Vorschrift einer statisch korrekten Ausführung die Gütefunktion bzw. Vielzahl der Dimensionierungskriterien die Voraussetzung dafür, dass im Falle von Zielkonflikten Kompromisse im Sinne eines kleinsten gemeinsamen Nenners auffindbar sind.

Pro vorläufigem Einbauplan kann eine Auswertung in mehreren Durchläufen stattfinden, welche mit der Gütefunktion getestet werden. Zur Suche der jeweils nächsten Variante kann ein beliebiges Optimierungsverfahren genutzt werden, das aus der Vorgeschichte der bisherigen Varianten eine neue Variante mit voraussichtlich besserem Wert der Gütefunktion ableitet. Dabei berücksichtigt der Abwandlungsalgorithmus auch gleichzeitig, dass die ermittelten Varianten stets im Rahmen der statischen Gültigkeit bleiben, das heißt, dass nicht eine Variante vorgeschlagen wird, welche die Grenzen der aufgrund des Momenten- und Querkraftverlaufs vorgegebenen Statikanforderungen verlässt.

Die im Abwandlungsmechanismus implementierte parametrierbare Gütefunktion kann vorzugsweise mehrere Dimensionierungskriterien P1 bis P5 berücksichtigen, welche maßliche, materielle und/oder modellmäßige Kriterien darstellen können. Ein maßliches Kriterium kann dabei ein Abstandsmaß zwischen benachbarten Bauteilen oder die Geometrie eines Bauteils sein. Ein materielles Kriterium kann den Werkstoff repräsentieren, aus dem das Betonteilverbindungselement, die angrenzenden Bauteile oder der zum Einbetonieren verwendete Beton besteht. Denn dies hat ebenfalls einen maßgeblichen Einfluss auf die Belastbarkeit. Als modellmäßige Kriterien kommen verschiedene Varianten von Betonteilverbindungselementen infrage, welche in der Regel als Baukastensystem bereitgestellt werden.

Die mehreren Dimensionierungskriterien können dem Planer - beispielsweise mittels eines auf einer grafischen Benutzeroberflache nachgebildeten Drehreglers - für verschiedene Optimierungsrichtungen einer Eingabemöglichkeit bereitstehen, um gewünschte Gewichtungen für Modifikationen des vorläufigen Einbauplans zu wählen. Das Assistenzsystem kann anhand des Abwandlungsalgorithmus ein aufeinander abgestimmtes, sinnvolles Verhältnis von verschiedenen vorgegebenen Dimensionierungskriterien ermitteln und einen zugehörigen alternativen Einbauplan vorschlagen. Im einfachsten Fall ist es jedoch auch denkbar, dass nur ein einziges Dimensionierungskriterium vorgebbar ist. Verschiedenste Dimensionierungskriterien P1 bis Pn sind denkbar, wovon nachfolgend eine nicht einschränkende Auswahl angegeben wird:
Ein erstes Dimensionierungskriterium P1 kann eine Auswahl zwischen verschiedenen Modellen von geeigneten Betonteil-Verbindungselementen beschreiben. So ist es beispielsweise denkbar, dass zwei kleinere Betonteil-Verbindungselemente durch ein einziges, größeres Betonteilverbindungselement ersetzt werden können.

Ein zweites Dimensionierungskriterium P2 kann einen vorzugebenden Abstand zwischen benachbarten Betonteil-Verbindungselementen beschreiben. So können beispielsweise weniger Betonteil-Verbindungselemente vorgegeben werden, falls die verwendeten Betonteilverbindungselemente eine entsprechend höhere Traglast aufweisen.

Ein drittes Dimensionierungskriterium P3 kann der Variation des senkrechten Gebäudekantenabstandes zum ersten Armierungsstab eines Betonteil-Verbindungselements dienen. Mit diesem Dimensionierungskriterium kann beispielsweise sichergestellt werden, dass ein hinreichender Abstand zum Einbetonieren der Armierungsstäbe verbleibt.

Ein viertes Dimensionierungskriterium P4 kann der Variation der Armierungsstababstande untereinander dienen, so dass bei einer Verringerung gegebenenfalls eine höhere Traglast desselben Betonteil-Verbindungselements erzielbar ist.

Ein fünftes Dimensionierungskriterium P5 kann für die Optimierung von Positionierungskoordinaten mindestens eines Befestigungshakens für ein Hebezeug am Betonteil dienen. Hierüber ist es möglich, geeignete Angriffspunkte eines Krans oder dergleichen am Betonteil zum Transport auf der Baustelle vorzugeben.

Gemäß einer weiteren die Erfindung verbessernden Maßnahme wird vorgeschlagen, dass die Umwandlung des vorläufigen Einbauplans in den mindestens einen alternativen Einbauplan ein Prüfen desselben auf Zulässigkeit bezüglich baurechtlicher Randbedingungen und/oder technischer Normen beinhaltet, die in einer entsprechenden Vorschriften-Datenbank hinterlegt sind. Hieraus können dem Assistenzsystem die erforderlichen Informationen zur Verfügung gestellt werden, so dass Fehlplanungen in einfacher Weise vermieden werden und sichergestellt ist, dass sämtliche einschlägigen Randbedingungen und Vorschriften beachtet werden.

Darüber hinaus wird gemäß einer weiteren optionalen Maßnahme vorgeschlagen, dass der alternative Einbauplan, welcher schlussendlich zur Realisierung ansteht, in der mit dem Planungsassistenzsystem verbundenen Vorschriften-Datenbank oder einer hierfür speziell vorgesehenen Datenbank hinterlegt wird, um diesen bei zukünftigen Umwandlungen gleicher oder ähnlicher vorläufiger Einbauplane als Vorlagevorschlag zu berücksichtigen. Dies reduziert die Auswahlzeit für die Realisierung geeigneter Unterlagen für eine Ausführungsplanung weiter.

Darüber hinaus eröffnet die erfindungsgemäße Lösung die Option, einen zu realisierenden alternativen Einbauplan vor tatsachlicher Montage auf der Baustelle einer amtlichen Vorzertifizierung zuzuführen, welche über eine digitale Kommunikationsschnittstelle des Planungssystems realisierbar ist, die einen hierfür vorgesehenen Datenaustausch mit einer zuständigen Behörde oder einem Sachverständigen gestattet und eventuell erforderliche Genehmigungsverfahren vereinfacht.

Es sind folgende Ausführungsformen der Erfindung erfasst, deren Aufzählung nicht abschließend ist:
1. Verfahren zur rechnergestützten Auswahl und Positionierung von Betonteil-Verbindungselementen (1, 1a, 1b), die zwischen einem von einem Gebäude (2) auskragenden Betonteil (3) und einer Gebäudefassade (4) angeordnet werden, umfassend die folgenden Schritte:
   - Erstellung (A) einer statischen Planung für ein an einer Gebäudefassade (4) anzubringendes auskragendes Betonteil (3) mit Ausgabe des Momenten- und Querkraftverlaufes,
   - Auswahl (B) von zu dem Momenten- und Querkraftverlauf passenden Betonteil-Verbindungselementen (1a', 1b') und Erstellung eines statisch gültigen vorläufigen Einbauplans (21) auf Basis des Momenten- und Querkraftverlaufes,
   - Modifikation (C) des vorläufigen Einbauplans (21) durch einen Abwandlungsalgorithmus (31) zur Erzeugung mindestens eines alternativen Einbauplans (32), wobei der Abwandlungsalgorithmus (31) zur Abwandlung des vorläufigen Einbauplans (21) in den alternativen Einbauplan (31) Werte einer hinsichtlich mehrerer Dimensionierungskriterien (P1
   - PS) parametrierbaren Gütefunktion ermittelt und den vorläufige Einbauplan (21) derart im Rahmen der statischen Gültigkeit abwandelt, dass die Gütefunktion ein Maximum annimmt.
2. Verfahren nach Ausführungsform 1,
   **dadurch gekennzeichnet,** dass die mehreren Dimensionierungskriterien (P1 - P5) maßliche, materielle und/oder modellmäßige Kriterien sind.
3. Verfahren nach Ausführungsform 2,
   **dadurch gekennzeichnet,** dass ein Dimensionierungskriterium (P1) als Auswahl zwischen verschiedenen Modellen von geeigneten Betonteil-Verbindungselementen (dd, 1', 15) ausgebildet ist.
4. Verfahren nach Ausführungsform 2,
   **dadurch gekennzeichnet,** dass ein Dimensionierungskriterium (P2) als Zwischenabstand (c) zwischen benachbarten Betonteil-Verbindungselementen (la, 1b) ausgebildet ist.
5. Verfahren nach Ausführungsform 2,
   **dadurch gekennzeichnet,** dass ein Dimensionierungskriterium (P3) als Gebäudekantenabstand (a) zwischen einer Gebäudekante (6) und einem ersten Armierungsstab (5) eines Betonteil-Verbindungselements (1) ausgebildet ist.
6. Verfahren nach Ausführungsform 2,
   **dadurch gekennzeichnet,** dass ein Dimensionierungskriterium (P4) als Armierungsstababstand (b) ausgebildet ist.
7. Verfahren nach Ausführungsform 2,
   **dadurch gekennzeichnet,** dass ein Dimensionierungskriterium (P5) als Positionierungskoordinaten mindestens eines Befestigungsankers (7, 7a) für einen Hebezeug am Betonteil (1) ausgebildet ist.
8. Verfahren nach Ausführungsform 1,
   **dadurch gekennzeichnet,** dass die Umwandlung des vorläufigen Einbauplans (21) in den mindestens einen alternativen Einbauplan (31) ein Prüfen (D) desselben auf Zulässigkeit bezüglich baurechtlicher Randbedingungen und/oder technischer Normen beinhaltet, die in einer Vorschriften-Datenbank (40) hinterlegt sind.
9. Verfahren nach Ausführungsform 1,
   **dadurch gekennzeichnet,** dass der alternative Einbauplan (31) in der mit dem Planungsassistenzsystem verbundenen Vorschriften-Datenbank (40) hinterlegt wird, um diesen bei zukünftigen Umwandlungen gleicher oder ähnlicher vorläufiger Einbauplane (21) als Vorschlag zu berücksichtigen.
10. Verfahren nach Ausführungsform 1,
   **dadurch gekennzeichnet,** dass der ausgewählte alternative Einbauplan (31) vor Montage eine Vorzertifizierung (E) auf normkonforme Umsetzung durchlauft.
11. Einrichtung zur rechnergestützten Auswahl und Positionierung von Betonteil-Verbindungselementen (1, 1a, 1b), die zwischen einem von einem Gebäude (2) auskragenden Betonteil (3) und einer Gebäudefassade (4) angeordnet sind, umfassend eine Statikplanungseinheit (10) zur Erstellung einer statischen Planung für ein an einer Gebäudefassade (4) anzubringendes auskragendes Betonteil (3) mit Ausgabe des Momenten- und Querkraftverlaufes (11), eine Auswahleinheit (20) zur Bestimmung von zu dem Momenten- und Querkraftverlauf passenden Betonteil-Verbindungselementen (1a', 1b') für die Erstellung eines statisch gültigen vorläufigen Einbauplans (21) auf Basis des Momenten- und Querkraftverlaufes, eine Modifikationseinheit (30) zur Abänderung des vorläufigen Einbauplans (21) durch einen hierin implementierten Abwandlungsalgorithmus (31) zur Erzeugung mindestens eines alternativen Einbauplans (32), wobei der Abwandlungsalgorithmus (31) zur Abwandlung des vorläufigen Einbauplans (21) in den alternativen Einbauplan (32) Werte einer hinsichtlich mehrerer Dimensionierungskriterien (P1 - P5) parametrierbare Gütefunktion ermittelt und den vorläufige Einbauplan (21) derart im Rahmen der statischen Gültigkeit abwandelt, dass die Gütefunktion ein Maximum annimmt.
12. Einrichtung nach Anspruch 11,
   **dadurch gekennzeichnet,** dass die Betonteil-Verbindungselemente (1, la, 1b) zumindest teilweise als digitalisiertes Modell eines tragenden Wärmedammelements ausgebildet sind.
13. Computerprogramm, umfassend Befehle, die bei der Ausführung des Programms durch eine Einrichtung gemäß Ausführungsform 11, diese veranlassen, die Schritte des Verfahrens gemäß einem der Ausführungsformen 1 bis 10 auszuführen.
14. Computerlesbarer Datenträger, auf dem das Computerprogramm nach Ausführungsform 12 gespeichert ist.

Weitere die Erfindung verbessernde Maßnahmen werden nachstehend gemeinsam mit der Beschreibung eines bevorzugten Ausführungsbeispiels der Erfindung anhand der Figuren naher dargestellt. Es zeigt:
- Fig. 1: eine schematische Darstellung einer Einrichtung zur rechnergestützten Auswahl und/oder Positionierung von Betonteil-Verbindungselementen, und
- Fig. 2: eine Ablaufdarstellung eines von der Einrichtung rechnergestützt durchgeführten Verfahrens.

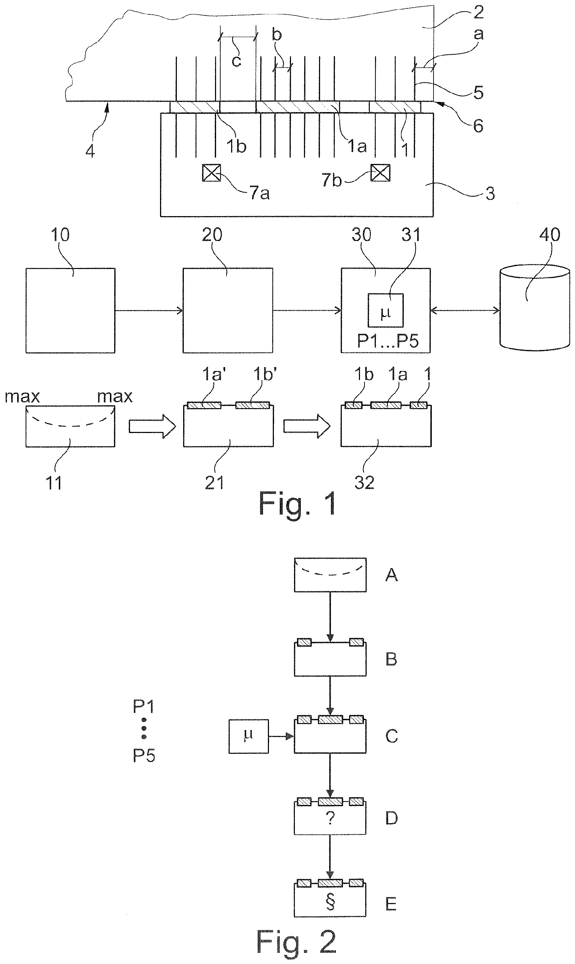

Gemäß Fig. 1 sind für den exemplarischen Anwendungsfall einer Balkonbefestigung Betonteil-Verbindungselemente 1, 1a und 1b vorgesehen, die zwischen einem von einem Gebäude 2 auskragenden Betonteil 3 in Form eines Fertigteilbalkons und einer Gebäudefassade 4 angeordnet. Als Betonteil-Verbindungselemente 1, 1a und 1b werden tragende Wärmedämmelemente verwendet, welche der bauaufsichtlichen Zulassung des DIBt sowie der europäischen technischen Bewertung gema4B EAD 050001-00-0301 entsprechen. Diese Betonteil-Verbindungselemente existieren im Rahmen eines Baukastensystems in verschiedenen Varianten gemäß Herstellernomenklatur.

In diesem Ausführungsbeispiel ist das als rechteckiger Balkon ausgebildete auskragende Betonteil 3 über drei Betonteil-Verbindungselemente 1, 1a und 1b mit jeweils sich zur Seite des Betonteils 3 und zur Seite des Gebäudes 2 erstreckenden Armierungsstäben ausgestattet. Die konkrete Auswahl und Positionierung der Betonteil-Verbindungselemente 1, 1a und 1b hat gemäß den statischen Erfordernissen zu erfolgen. Eine erfindungsgemäße rechnergestützte Einrichtung dient dabei als Assistenzsystem für eine baustellengerechte Ausführungsplanung.

Die Einrichtung umfasst eine Statikplanungseinheit 10, welche auch separat ausgebildet sein kann, zur Erstellung einer statischen Planung für ein an der Gebäudefassade 4 anzubringendes auskragendes Betonteil 3. Die Statikplanungseinheit 10 gibt unter anderem den dimensierungsrelevanten Momenten- und Querkraftverlauf 11 als Planungsergebnis aus.

Eine nachgeschaltete Auswahleinheit 20 dient der Bestimmung von zu dem Momenten- und Querkraftverlauf der vorausgehenden statischen Planung passenden Betonteil-Verbindungselement 1a' und 1b' für die Erstellung eines statisch gültigen vorläufigen Einbauplans 21, welcher zunächst nicht dem eingangs beschriebenen Einbauplan entspricht.

Eine nachfolgende Modifikationseinheit 30 dient einer anschließenden Abänderung des vorläufigen Einbauplans 21 durch einen hierin implementierten Abwandlungsalgorithmus 31 zur Erzeugung mindestens eines alternativen Einbauplans 32, welcher dem eingangs beschriebenen Einbauplan entspricht.

Der Abwandlungsalgorithmus 31 der Modifikationseinheit 30 wandelt den vorläufigen Einbauplan 21 in den alternativen Einbauplan 32 ab, indem Werte einer hinsichtlich mehrerer Dimensionierungskriterien P1 bis PS parametrierbare Gütefunktion ermittelt und den vorläufigen Einbauplan 21 derart im Rahmen der statischen Gültigkeit abwandelt, dass die Gütefunktion ein Maximum annimmt. Hierdurch entspricht der alternative Einbauplan 32 ebenfalls den statischen Vorgaben hinsichtlich des geforderten Momenten- und Querkraftverlaufs 11 und beinhaltet außerdem eine insbesondere maßliche, materielle und/oder modellmäßige Optimierung der zum Einsatz kommenden Betonteil-Verbindungselemente 1, 1a und 1b sowie deren Positionierung relativ zum Gebäude 2 und dem hiervon auskragenden Betonteil 3.

Die Statikplanungseinheit 10, die Auswahleinheit 20 sowie die Abwandlungseinheit 30 sind in einem Arbeitsplatzrechner integriert und mit einer Vorschriften-Datenbank 40 verbunden. Hierdurch hat das Assistenzsystem Zugriff auf dimensionierungsrelevante technische Normen sowie baurechtliche Randbedingungen, welche bei der Abwandlung des vorläufigen Einbauplans 21 zu beachten sind.

Nach Fig. 2 führt das vorstehend beschriebene Assistenzsystem zur erfindungsgemäßen Auswahl und Positionierung der Betonteil-Verbindungselemente 1, 1a und 1b die folgenden Schritte durch:
Zunächst findet eine Erstellung A einer statischen Planung für ein an einer Gebäudefassade anzubringendes auskragendes Betonteil mit Ausgabe des Momenten- und Querkraftverlaufs statt.

Anschließend erfolgt eine Auswahl B von zu dem Momenten- und Querkraftverlauf passenden Betonteil-Verbindungselementen sowie eine Erstellung eines statisch gültigen vorläufigen Einbauplans auf Basis des Momenten- und Querkraftverlaufs.

Danach findet eine Modifikation C des vorläufigen Einbauplans durch einen Abwandlungsalgorithmus zur Erzeugung mindestens eines alternativen Einbauplans statt, wobei der Abwandlungsalgorithmus Werte einer hinsichtlich vorzugsweise mehrerer Dimensionierungskriterien P1 bis P5 parametrierbaren Gütefunktion ermittelt und den vorläufigen Einbauplan derart im Rahmen der statischen Gültigkeit abwandelt, dass die Gütefunktion ein Maximum annimmt, wodurch eine mehrdimensionale sich gegenseitig anpassende Optimierung stattfindet.

Ein nachfolgendes Prüfen D des alternativen Einbauplans auf Zulässigkeit bezüglich baurechtlicher Randbedingungen und/oder technischer Normen dient einer Absicherung des Abwandlungsergebnisses.

Final wird im Rahmen einer Vorzertifizierung E der geprüfte alternative Einbauplan durch eine autorisierte Behörde und/oder einen Sachverständigen im Rahmen einer digitalisierten Vorzertifizierung genehmigt. Die Erfindung ist nicht beschränkt auf das vorstehend beschriebene bevorzugte Ausführungsbeispiel. Es sind vielmehr auch Abwandlungen hiervon denkbar, welche vom Schutzbereich der nachfolgenden Ansprüche mit umfasst sind. So ist es beispielsweise auch möglich, andere auskragende Betonteile mit den hier interessierenden Betonteil-Verbindungselementen zu verbinden. Diese können anstelle der einzubetonierenden Armierungsstabe auch eine zumindest einseitige andere Anschlusskonfiguration aufweisen.

### Bezugszeichenliste

- 1: Betonteil-Verbindungselement
- 2: Gebäude
- 3: auskragendes Betonteil
- 4: Gebäudefassade
- 5: Armierungsstab
- 6: Gebäudekante
- 7: Befestigungsanker

- 10: Statikplanungseinheit
- 11: Momenten- und Querkraftverlauf
- 20: Auswahleinheit
- 21: vorläufiger Einbauplan
- 30: Modifikation
- 31: Abwandlungsalgorithmus
- 32: alternativer Einbauplan
- 40: Vorschriften-Datenbank

- P1-Pn: Dimensionierungskriterien
- a: Gebäudeabstand
- b: Armierungsabstand
- c: Zwischenabstand

## Patentansprüche

1. Verfahren zur Auswahl und/oder Positionierung von mindestens einem Betonteil-Verbindungselement (1, 1a, 1b), welches bzw. welche vorgesehen ist/sind, zwischen einem von einem Gebäude (2) auskragenden Betonteil (3) und einer Gebäudefassade (4) angeordnet zu werden, umfassend die folgenden Schritte:
- Modifizieren (C) eines statisch gültigen vorläufigen Einbauplans (21) durch einen Abwandlungsalgorithmus (31) zur Erzeugung mindestens eines alternativen Einbauplans (32), wobei der Abwandlungsalgorithmus (31) zur Abwandlung des vorläufigen Einbauplans (21) in den alternativen Einbauplan (31) Werte einer hinsichtlich mehrerer Dimensionierungskriterien (P1, P2, P3, P4, P5) parametrierbaren Gütefunktion ermittelt und den vorläufigen Einbauplan (21) derart im Rahmen der statischen Gültigkeit abwandelt, dass die Gütefunktion ein Maximum annimmt; und
- Ausgeben des alternativen Einbauplans (31).

2. Verfahren zum Einbauen mindestens eines Betonteil-Verbindungselements (1, 1a, 1b) zwischen einem von einem Gebäude (2) auskragenden Betonteil (3) und einer Gebäudefassade (4), umfassend die folgenden Schritte:
- Modifizieren (C) eines statisch gültigen vorläufigen Einbauplans (21) durch einen Abwandlungsalgorithmus (31) zur Erzeugung mindestens eines alternativen Einbauplans (32), wobei der Abwandlungsalgorithmus (31) zur Abwandlung des vorläufigen Einbauplans (21) in den alternativen Einbauplan (31) Werte einer hinsichtlich mehrerer Dimensionierungskriterien (P1, P2, P3, P4, P5) parametrierbaren Gütefunktion ermittelt und den vorläufigen Einbauplan (21) derart im Rahmen der statischen Gültigkeit abwandelt, dass die Gütefunktion ein Maximum annimmt;
- Ausgeben des alternativen Einbauplans (31); und
- Einbauen des mindestens einen Betonteil-Verbindungselements (1, 1a, 1b).

3. Verfahren nach Anspruch 1 oder 2, wobei die Dimensionierungskriterien (P1, P2, P3, P4, P5) technische Ausgestaltungen der Auswahl und/oder Positionierung betreffen, die eine die statische Gültigkeit berücksichtigende a) Auswahl aus mehreren vorgegebenen Betonteil-Verbindungselementen (1, 1a, 1b), b) Wahl des Werkstoffs für das Betonteil-Verbindungselements (1, 1a, 1b) und/oder eines für ein Einbetonieren verwendeten Betons, c) Positionierung des einen Betonteil-Verbindungselements (1, 1a, 1b) oder mehrerer Betonteil-Verbindungselemente (1, 1a, 1b) zueinander, und/oder d) technische Modifikation des Betonteil-Verbindungselements (1, 1a, 1b) betreffen.

4. Verfahren nach einem der Ansprüche 1 bis 3, wobei der technische Zusammenhang über die statische Gültigkeit erhalten bleibt, wenn mindestens ein Parameterwert eines Dimensionierungskriteriums (P1, P2, P3, P4, P5) verändert wird, indem die Parameterwerte der anderen Dimensionierungskriterien (P1, P2, P3, P4, P5) unter Beibehaltung der statischen Gültigkeit in Abhängigkeit auf die Veränderung des mindestens einen Parameterwerts angepasst werden.

5. Verfahren nach einem der Ansprüche 1 bis 4, wobei als Parameter der Gütefunktion die Abmessungen des Betonteils (3), der Werkstoff des Betonteils (3), das Gewicht des Betonteils (3), ein zum Einbetonieren verwendeter Beton, eine technische Ausgestaltung des Betonteil-Verbindungselements (1, 1a, 1b) und/oder mindestens ein Abstand des Betonteil-Verbindungselements zum Betonteil (3), zur Gebäudefassade (4) und/oder zu einem weiteren Betonteil-Verbindungselement (1, 1a, 1b) gewählt werden.

6. Verfahren nach einem der Ansprüche 1 bis 5, **dadurch gekennzeichnet, dass** die mehreren Dimensionierungskriterien (P1 - P5) maßliche, materielle und/oder modellmäßige Kriterien sind.

7. Verfahren nach einem der Ansprüche 1 bis 6, **dadurch gekennzeichnet, dass** ein Dimensionierungskriterium (P1) als Auswahl zwischen verschiedenen Modellen von geeigneten Betonteil-Verbindungselementen (dd, 1', 15) ausgebildet ist.

8. Verfahren nach einem der Ansprüche 1 bis 7, **dadurch gekennzeichnet, dass** ein Dimensionierungskriterium (P2) als Zwischenabstand (c) zwischen benachbarten Betonteil-Verbindungselementen (la, 1b) ausgebildet ist.

9. Verfahren nach einem der Ansprüche 1 bis 8, **dadurch gekennzeichnet, dass** ein Dimensionierungskriterium (P3) als Gebäudekantenabstand (a) zwischen einer Gebäudekante (6) und einem ersten Armierungsstab (5) eines Betonteil-Verbindungselements (1) ausgebildet ist.

10. Verfahren nach einem der Ansprüche 1 bis 9, **dadurch gekennzeichnet, dass** ein Dimensionierungskriterium (P4) als Armierungsstababstand (b) ausgebildet ist.

11. Verfahren nach einem der Ansprüche 1 bis 10, **dadurch gekennzeichnet, dass** ein Dimensionierungskriterium (P5) als Positionierungskoordinaten mindestens eines Befestigungsankers (7, 7a) für einen Hebezeug am Betonteil (1) ausgebildet ist.

12. Verfahren nach einem der Ansprüche 1 bis 11, **dadurch gekennzeichnet, dass** die Umwandlung des vorläufigen Einbauplans (21) in den mindestens einen alternativen Einbauplan (31) ein Prüfen (D) desselben auf Zulässigkeit bezüglich baurechtlicher Randbedingungen und/oder technischer Normen beinhaltet, die in einer Vorschriften-Datenbank (40) hinterlegt sind.

13. Verfahren nach einem der Ansprüche 1 bis 12, **dadurch gekennzeichnet, dass** der alternative Einbauplan (31) in der mit dem Planungsassistenzsystem verbundenen Vorschriften-Datenbank (40) hinterlegt wird, um diesen bei zukünftigen Umwandlungen gleicher oder ähnlicher vorläufiger Einbauplane (21) als Vorschlag zu berücksichtigen.

14. Verfahren nach einem der Ansprüche 1 bis 13, **dadurch gekennzeichnet, dass** der ausgewählte alternative Einbauplan (31) vor Montage eine Vorzertifizierung (E) auf normkonforme Umsetzung durchläuft.

15. Einrichtung zur Auswahl und/oder Positionierung von mindestens einem Betonteil-Verbindungselement (1, 1a, 1b), welches bzw. welche vorgesehen ist/sind, zwischen einem von einem Gebäude (2) auskragenden Betonteil (3) und einer Gebäudefassade (4) angeordnet zu sein, umfassend:
- eine Modifikationseinheit (30) zur Abänderung eines statisch gültigen vorläufigen Einbauplans (21) durch einen hierin implementierten Abwandlungsalgorithmus (31) zur Erzeugung mindestens eines alternativen Einbauplans (32), wobei der Abwandlungsalgorithmus (31) zur Abwandlung des vorläufigen Einbauplans (21) in den alternativen Einbauplan (32) Werte einer hinsichtlich mehrerer Dimensionierungskriterien (P1 - P5) parametrierbare Gütefunktion ermittelt und den vorläufige Einbauplan (21) derart im Rahmen der statischen Gültigkeit abwandelt, dass die Gütefunktion ein Maximum annimmt; und
- eine Ausgabeeinheit zum Ausgeben des alternativen Einbauplans (31).
